# EUROPÄISCHE PATENTANMELDUNG

(11) **EP 1 873 899 A2**
(43) Veröffentlichungstag der Anmeldung: **02.01.2008**
(21) Anmeldenummer: 07010173.8
(22) Anmeldetag: 22.05.2007
(51) Int. Cl.: H02P 7/24

(54) **Lüftersteuerung und Verfahren zur Einstellung der Drehzahl eines Lüfters**

(30) Priorität: 28.06.2006 DE 102006029723
(71) Anmelder: Fujitsu Siemens Computers GmbH, 80807 München (DE)
(72) Erfinder: Ahn, Georg, 86179 Augsburg (DE); Gremes, Manuel, 86199 Augsburg (DE); Sausenthaler, Werner, 82278 Althengnenberg (DE); Scharr, Klaus, 86681 Fünfstetten (DE)
(74) Vertreter: Epping - Hermann - Fischer

(57) **Zusammenfassung**

Die Erfindung betrifft eine Lüftersteuerung (LS) und ein Verfahren zur Einstellung der Drehzahl eines Lüfters. Die Lüftersteuerung (LS) ist dazu eingerichtet den Lüfter in einem ersten Temperaturbereich einer Lüfterkennlinie auf einer konstanten Drehzahl zu halten. Die Lüftersteuerung (LS) weist einen digitalen Vergleicher (DV) zum Vergleich einer erfassten Ist-Drehzahl mit einer vorgegebenen Minimal-Soll-Drehzahl in dem ersten Temperaturbereich auf.

## Beschreibung

Die Erfindung betrifft eine Lüftersteuerung, die dazu eingerichtet ist, einen Lüfter in einem ersten Temperaturbereich einer Lüfterkennlinie auf einer konstanten Drehzahl zu halten, und ein Verfahren zur Einstellung einer Drehzahl eines Lüfters.

Ein Computersystem weist meist eine Lüfterkühlung für seine elektronischen Komponenten auf. Steigt beispielsweise die Betriebstemperatur eines Prozessors des Computersystems, wird die Drehzahl eines dem Prozessor zur Kühlung zugeordneten Lüfters erhöht und ein Überhitzen des Prozessors wird verhindert. Eine Steuerung der Drehzahl des Lüfters wird üblicherweise durch ein Ändern einer Steuerspannung für den Lüfter erreicht.

Die Steuerspannung für den Lüfter ergibt sich üblicherweise aus einer Lüfterkennlinie. Die Steuerspannung steigt in einem bestimmten Temperaturbereich von einem Grundspannüngspegel zur maximalen Steuerspannung für den Lüfter an. Mit steigender Steuerspannung erhöht sich die Drehzahl des Lüfters. Ein rotierender Lüfter erzeugt einen Hörschall bestimmter Lautstärke und Frequenz. Eine Erhöhung der Drehzahl des Lüfters führt auch zu einem höheren Geräuschpegel.

Zur Geräuschreduzierung wird versucht die Drehzahl des Lüfters gering zu halten. Die Lüfterspannung in einem ersten Temperaturbereich einer Lüfterkennlinie wird üblicherweise konstant gehalten. Das heißt, dass die Steuerspannung für den Lüfter bis zu einem Schwellwert steigender Betriebstemperatur der elektronischen Komponente konstant bleibt, wobei die zur Kühlung der elektronischen Komponente des Computersystems notwendige Kühlleistung gewährleistet ist.

Dieser Temperaturbereich liegt insbesondere im so genannten "IDLE" Betrieb vor. Das heißt, dass ein Computersystem eingeschaltet und nicht weiter belastet ist.

Überschreitet die Betriebstemperatur der elektronischen Komponente den Schwellwert und ist kleiner als die für die elektronische Komponente maximal zulässige Betriebstemperatur, ist also in einem zweiten Temperaturbereich, erfolgt üblicherweise die Steuerung der Drehzahl des Lüfters mit einer steigenden Lüfterkennlinie.

Da unterschiedliche Lüftertypen, aber auch verschiedene Lüfter eines Typs ein abweichendes Verhalten aufweisen, ist die Ansteuerung gemäß einer solchen Lüfterkennlinie oft nicht optimal.

Das Problem des unterschiedlichen Verhaltens der Lüfter wurde bisher teilweise gar nicht beachtet oder durch Verwendung eng spezifizierter Lüfter "behoben". Allerdings ist diese Lösung teuer und erfordert das Verwenden gleicher, nämlich der eng spezifizierten Lüfter.

Der Erfindung liegt daher die Aufgabe zugrunde, eine Lüftersteuerung anzugeben, die Lüfter so ansteuert, dass ein individuell unterschiedliches Verhalten berücksichtigt wird.

Die Aufgabe wird erfindungsgemäß durch eine Lüftersteuerung gelöst, die dazu eingerichtet ist, einen Lüfter in einem ersten Temperaturbereich einer Lüfterkennlinie auf einer konstanten Drehzahl zu halten. Die Lüftersteuerung ist erfindungsgemäß dadurch gekennzeichnet, dass sie einen digitalen Vergleicher aufweist zum Vergleich einer erfassten Ist-Drehzahl mit einer vorgegebenen Minimal-Soll-Drehzahl in dem ersten Temperaturbereich.

Das Verwenden der erfindungsgemäßen Lüftersteuerung in einem oder mehreren Computersystemen gewährleistet eine sehr gute Kühlung der elektronischen Komponenten der jeweiligen Computersysteme. Dabei wird die Drehzahl der baugleichen oder verschiedenen Lüfter mit der Lüftersteuerung derartig geregelt, dass die Lüfter in dem ersten Temperaturbereich der Lüfterkennlinien genau mit der vorgegebenen Minimal-Soll-Drehzahl betrieben werden. Wenn die Lüfter mit der gleichen, nämlich der Minimal-Soll-Drehzahl betrieben werden, ist auch die Frequenz der bei rotierenden Lüftern entstehenden Schallwellen (Ton) gleich. Damit ist gewährleistet, dass bei einer additiven Überlagerung der Schallwellen ein Ton entsteht, der nicht moduliert ist. Wären die Lüfterdrehzahlen und damit die Frequenzen der Schallwellen leicht unterschiedlich, entstünde ein modulierter Ton dessen Lautstärke mit der Schwebungsfrequenz aus der Überlagerung der Schallwellen unterschiedlicher Frequenz schwanken würde. Einen derartigen Ton empfände ein Benutzer als unangenehm.

Zur Lösung der Aufgabe wird ebenfalls ein Verfahren zur Einstellung der Drehzahl eines Lüfters mit den Merkmalen des Anspruchs 7 angegeben. Demnach werden eine Temperatur und die Ist-Drehzahl des Lüfters gemessen. Die Lüftersteuerung prüft, ob für eine Temperatur im ersten Temperaturbereich die erfasste Ist-Drehzahl gleich der Minimal-Soll-Drehzahl ist und regelt bei einer Abweichung die Drehzahl des Lüfters bis zum Erreichen der Minimal-Soll-Drehzahl.

Zur Ansteuerung des Lüfters ist in einer vorteilhaften Weiterbildung der Erfindung eine Pulsweitenmodulation vorgesehen. Das heißt, dass die Drehzahl des Lüfters über ein pulsweitenmoduliertes Ansteuerungssignal gesteuert wird. Die Pulsweitenmodulation ist auch als Pulsbreitenmodulation oder Pulsdauermodulation bekannt.

In einer weiteren vorteilhaften Ausführungsform ist die Lüftersteuerung dazu eingerichtet, eine Fehlermeldung auszugeben, wenn das Tastverhältnis des pulsweitenmodulierten Ansteuerungssignals einen Wert von 0% erreicht und die Ist-Drehzahl des Lüfters über der Minimal-Soll-Drehzahl liegt. Die Lüftersteuerung ist auch dazu eingerichtet, eine Fehlermeldung auszugeben, wenn das Tastverhältnis des pulsweitenmodulierten Ansteuerungssignals einen festzulegenden Maximalwert (z.B. 100%) erreicht und die erfasste Temperatur der zu kühlenden Computerkomponente oberhalb einer zulässigen Maximaltemperatur liegt.

Weitere Einzelheiten und Ausgestaltungen der Erfindung sind in den Unteransprüchen angegeben.

Die Erfindung wird nachfolgend an Ausführungsbeispielen anhand der Zeichnungen näher erläutert.

In den Zeichnungen zeigen:
- Figur 1: ein Blockschaltbild eines ersten Ausführungsbeispiels,
- Figur 2a: ein Diagram mit Drehzahlen zweier Lüfter in Abhängigkeit einer Temperatur
- Figur 2b: ein Diagram mit Drehzahlen zweier Lüfter in Abhängigkeit von Tastverhältnissen pulsweitenmodulierter Ansteuerungssignale
- Figur 3: ein Blockschaltbild eines zweiten Ausführungsbeispiels,
- Figur 4: ein Blockschaltbild eines dritten Ausführungsbeispiels,
- Figur 5: ein Flussdiagramm eines Verfahrens, und
- Figur 6: ein Ausschnitt aus einem Flussdiagram eines Verfahrens.

In den folgenden Ausführungsbeispielen werden die genannten Lüfter über einen Transistor gesteuert, wobei der Transistor von der Lüftersteuerung angesteuert wird. Es ist auch möglich einen Lüfter mit integrierter Ansteuerlogik mit einer erfindungsgemäßen Lüftersteuerung anzusteuern. Ein derartiger Lüfter wird von der Lüftersteuerung mit Ansteuerungssignalen angesteuert.

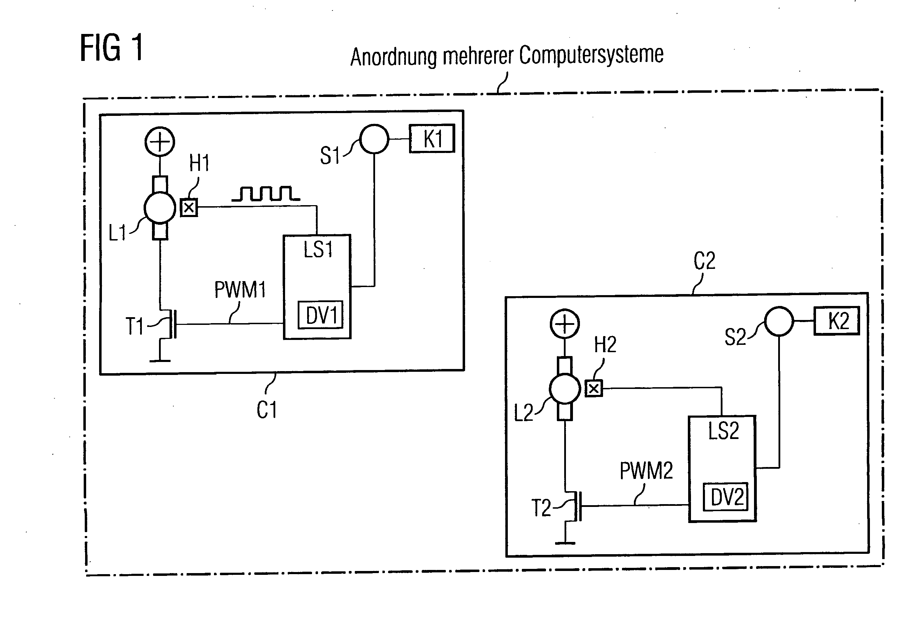

Figur 1 zeigt ein Blockschaltbild eines ersten Ausführungsbeispiels erfindungsgemäßer Lüftersteuerungen in zwei Computersystemen.

Ein von einem Motor angetriebener Lüfter L1 kühlt eine elektronische Komponente K1 eines Computersystems C1. Ein zweiter von einem Motor angetriebener Lüfter L2 kühlt eine elektronische Komponente K2 eines Computersystems C2. Die beiden Computersysteme C1 und C2 gehören zu einer gleichen Familie von Computersystemen.

Weitere Lüfter und elektronische Komponenten der Computersysteme C1, C2 werden aus Gründen einer einfachen Erläuterung der Erfindung nicht explizit erwähnt, sind aber in der weiteren Beschreibung auch gemeint. Die elektronischen Komponenten K1, K2 können gleicher oder verschiedener Bauart sein.

Im Computersystem C1 wird die Temperatur der elektronischen Komponente K1 von einem Temperatursensor S1 gemessen und an eine Lüftersteuerung LS1 weitergeleitet. Die Lüftersteuerung LS1 weist einen digitalen Vergleicher DV1 auf und steuert einen Transistor T1 mit einem pulsweitenmodulierten Ansteuerungssignal PWM1 an, wodurch die mittlere Leistung des Lüfters L1 gesteuert wird.

Eine Ist-Drehzahl des Lüfters L1 wird von einem Drehzahlmesser H1 erfasst und ebenfalls an die Lüftersteuerung LS1 weitergeleitet. Der Drehzahlmesser H1 leitet die gemessene Ist-Drehzahl des Lüfters L1 als ein digitales Signal an die Lüftersteuerung LS1 weiter. Das gemessene Signal könnte auch als analoges Signal weitergeleitet werden und für den Vergleich in der Lüftersteuerung in ein digitales Signal umgewandelt werden.

Im Computersystem C2 wird die Temperatur der elektronischen Komponente K2 auch von einem Temperatursensor S2 gemessen und an eine Lüftersteuerung LS2 mit einem digitalen Vergleicher DV2 weitergeleitet. Die Lüftersteuerung LS2 steuert einen Transistor T2 mit einem pulsweitenmodulierten Ansteuerungssignal PWM2 an. Die Ist-Drehzahl des Lüfters L2 wird von einem Drehzahlmesser H2 erfasst und ebenfalls als digitales Signal an die Lüftersteuerung LS2 weitergeleitet.

Die Temperatur innerhalb eines Computersystems oder seiner zu kühlenden elektronischen Komponenten wird an einer oder verschiedenen Stellen des Computersystems gemessen. Dabei wird die Temperatur der Komponenten in deren unmittelbaren Nähe oder indirekt über die Temperatur der Luft im Gehäuse erfasst. Der Temperatursensor ist zum Beispiel ein so genannter NTC- oder PTC-Widerstand. Das ist ein Widerstand dessen Widerstandswert bei Abkühlung beziehungsweise Erwärmung größer wird.

Die Drehzahlmesser H1 und H2 können beispielsweise Hallsensoren sein. Stattdessen könnte das Drehzahlsignal auch von dem Lüfter selber zur Verfügung gestellt werden. Solche Lüfter besitzen eine interne Elektronik, in der das gewünschte Signal ohnehin zur Verfügung steht. Allerdings sind solche Lüfter teuer.

Die Lüftersteuerung LS1 ist beispielsweise ein Mikrocontroller durch den unter anderem der digitale Vergleicher DV1 realisiert ist.

Beim Einschalten der Computersysteme C1 und C2 wird in einem Ausführungsbeispiel jeweils eine Kalibrierung der eingebauten Lüfter L1 und L2 durchgeführt. Zum Beispiel wird der Lüfter L1 des Computersystems C1 zur Kalibrierung mit einer hohen, vorbestimmten Drehzahl betrieben. Das Tastverhältnis des pulsweitenmodulierten Ansteuerungssignals zum Erreichen dieser Drehzahl ist eine Kalibrierungsgröße für den Lüfter L1. Zukünftige Einstellungen der Drehzahl des Lüfter L1 berücksichtigen diesen Kalibrierungswert.

Der Lüfter L2 des Computersystems C2 wird zur Kalibrierung mit der gleichen hohen Drehzahl wie der Lüfter L1 betrieben.

Das Tastverhältnis des pulsweitenmodulierten Ansteuerungssignals zum Erreichen dieser Drehzahl ist eine Kalibrierungsgröße für den Lüfter L2 und wird auch bei zukünftigen Einstellungen der Drehzahl des Lüfters L2 berücksichtigt.

Der Vorteil der durchgeführten Kalibrierung ist ein Test der Funktionalität und eine gleichzeitige Überprüfung des Alterungsprozesses der Lüfter L1 und L2. Eine altersbedingte Änderung der Lüftercharakteristik kann somit bei der Steuerung berücksichtigt werden. Die Durchführung einer derartigen Kalibrierung ist nicht auf dieses Ausführungsbeispiel beschränkt, sondern ist sogar unabhängig von der Regelung auf eine Minimal-Soll-Drehzahl in einem ersten Temperaturbereich, das heißt bei konventionellen Lüftersteuerungen möglich.

Liegt die vom Temperatursensor S1 gemessene Temperatur in einem ersten Temperaturbereich einer Lüfterkennlinie des Lüfters L1, ergibt sich eine Soll-Drehzahl des Lüfters L1 gleich einer vorgegebenen Minimal-Soll-Drehzahl. Wird für den Lüfter L1 vom digitalen Vergleicher DV1 eine Abweichung der Ist-Drehzahl von der Minimal-Soll-Drehzahl festgestellt, wird die Drehzahl des Lüfters L1 mit einem pulsweitenmodulierten Ansteuerungssignal PWM1 auf die Minimal-Soll-Drehzahl geregelt. Diese Regelung erfolgt, indem das Tastverhältnis des pulsweitenmodulierten Ansteuerungssignals PWM1 verändert wird.

Die Drehzahl des Lüfters L2 wird von der Lüftersteuerung LS2 auch auf die gleiche vorgegebenen Minimal-Soll-Drehzahl geregelt, wenn die vom Temperatursensor S2 gemessene Temperatur der elektronischen Komponente K2 in einem ersten Temperaturbereich der Lüfterkennlinie des Lüfters L2 liegt.

Beide Lüfter L1 und L2 laufen mit der gleichen Drehzahl, nämlich der Minimal-Soll-Drehzahl weiter, wenn die gemessenen Temperaturen der elektronischen Komponenten K1 und K2 einen Schwellwert nicht überschreiten. Der Schwellwert ist von der Lüfterkennlinie festgelegt und liegt vorzugsweise verhältnismäßig nahe der maximal zulässigen Temperatur für die elektronische Komponente. Bis zum Erreichen des jeweiligen Schwellwerts der Temperatur ist ein einwandfreier Betrieb der elektronischen Komponenten K1 und K2 gewährleistet.

Ist die Belastung der Computersysteme C1 und C2 verschieden und eines der Computersysteme C2 wird stärker belastet, steigt die Temperatur der elektronischen Komponente K2 des stärker belasteten Computersystems C2 über den Schwellwert in einen zweiten Temperaturbereich der Lüfterkennlinie des Lüfters L2. Die Lüftersteuerung LV2 steuert die Drehzahl des Lüfters L2 so, dass die Soll-Drehzahl für die vom Temperatursensor S2 erfasste Temperatur erreicht wird. Der digitale Vergleicher DV2 vergleicht die Ist-Drehzahl des Lüfters L1 mit der Soll-Drehzahl. Bei einer Abweichung regelt der digitale Vergleicher DV2 die Drehzahl des Lüfters L2 durch Verändern des Tastverhältnisses des pulsweitenmodulierten Ansteuerungssignals PWM2.

Werden beide Lüfter L1 und L2 in dem zweiten Temperaturbereich ihrer jeweiligen Lüfterkennlinie betrieben, können die jeweiligen Soll-Drehzahlen unterschiedlich sein. Durch die zuvor erwähnte Kalibrierung oder aufgrund entsprechender Programmierung der Lüfterkennlinie kann die maximale Kühlleistung eines Lüfters ausgenutzt werden. Die maximale Drehzahl kann also je nach Lüfter unterschiedlich sein.

Die digitalen Vergleicher DV1 und DV2 regeln die Drehzahl der Lüfter L1 und L2 zur jeweiligen Soll-Drehzahl.

Um einen sicheren Betrieb der Lüfter L1 und L2 zu gewährleisten, wird von der Lüftersteuerung LS1 bzw. LS2 eine Fehlermeldung ausgegeben, wenn das Tastverhältnis eines der pulsweitenmodulierten Ansteuerungssignale PWM1 bzw. PWM2 einen Wert von 0% erreicht und die Ist-Drehzahl des betreffenden Lüfters L1 bzw. L2 über der Minimal-Soll-Drehzahl liegt. Bei einem Tastverhältnis von 0% lässt sich die Minimal-Soll-Drehzahl für den betreffenden Lüfter L1 bzw. L2 nicht mehr einstellen. Der Lüfter L1 bzw. L2 sollte in diesem Fall ausgetauscht werden. Die Fehlermeldung kann beispielsweise auf einem an das Computersystem C1 bzw. C2 angeschlossenen Bildschirmgerät eingeblendet werden.

Es wird auch eine Fehlermeldung ausgegeben, wenn die Temperatur der elektronischen Komponente K1 bzw. K2 oberhalb der zulässigen Betriebstemperatur liegt und das Tastverhältnis der pulsweitenmodulierten Ansteuerungssignals PWM1 bzw. PWM2 einen festzulegenden maximalen Wert, beispielsweise 100% erreicht. In diesem Fall ist keine ausreichende Kühlleistung des betreffenden Lüfters L1 bzw. L2 vorhanden. Der festzulegende maximale Wert des Tastverhältnisses der pulsweitenmodulierten Ansteuerungssignals PWM1 bzw. PWM2 wird auf einen Wert festgelegt, so dass ein genügend großer Regelbereich für die Kühlung des Systems zur Verfügung steht. Das heißt, dass der festzulegende maximale Wert nicht zu klein gewählt werden sollte.

Durch die Vorgabe der gleichen Minimal-Soll-Drehzahl in beiden Computersystemen C1 und C2 ist auch die Frequenz der durch die Lüfterrotation entstehenden Schallwellen gleich.

Damit ist gewährleistet, dass durch die additive Überlagerung der Schallwellen ein Ton entsteht, der nicht moduliert ist. Erst bei einer deutlich höheren Belastung, beispielsweise des Computersystems C2, ändert sich die Lüfterdrehzahl der Lüfter dieses Computersystems C2 zu einem Wert ungleich der Minimal-Soll-Drehzahl.

Die zwei Lüfter L1 und L2 können verschiedene oder baugleiche Lüfter sein. Verschiedene oder auch baugleiche Lüfter weisen Toleranzen für ihre Drehzahlen auf. Durch die digitale Erfassung der Ist-Drehzahl der Lüfter L1 und L2 und durch die digitale oder analoge Steuerung der Drehzahlen durch die digitalen Vergleicher DV1 und DV2 ist das Einstellen eines exakten Drehzahlwerts der Lüfter L1 und L2 mit einer vernachlässigbar kleinen Toleranz möglich.

Durch das Verwenden einer Lüftersteuerung gemäß einem Ausführungsbeispiel der Erfindung ist nur die Minimal-Soll-Drehzahl vorgegeben. Die Drehzahl der Lüfter ist durch die Lüfterregelung nicht nach oben beschränkt. Die Lüftersteuerung ist so ausgelegt, dass jeder Lüfter mit einer maximalen Leistung betrieben werden kann, indem ohne Berücksichtigung der Drehzahl die maximale Spannung am Lüfter angelegt wird. Ist eine elektronische Komponente eines Computersystems sehr heiß geworden, wird der für die Kühlung zugeordnete Lüfter bei maximaler Drehzahl betrieben werden, wobei sich diese von Lüfter zu Lüfter unterscheiden kann. Dadurch erreicht man mit der erfindungsgemäßen Lüftersteuerung auch für ein alterndes Computersystem eine zum einwandfreien Betrieb erforderliche Kühlleistung. Höhere Drehzahlen, als für die Kühlung eines neuen Computersystems erforderlich sind, können dadurch erreicht werden. Während also in einem ersten Temperaturbereich die Drehzahl geregelt wird, erfolgt in einem zweiten Temperaturbereich eine Regelung bis zur maximalen Lüfterspannung unabhängig von der dann erreichten Drehzahl.

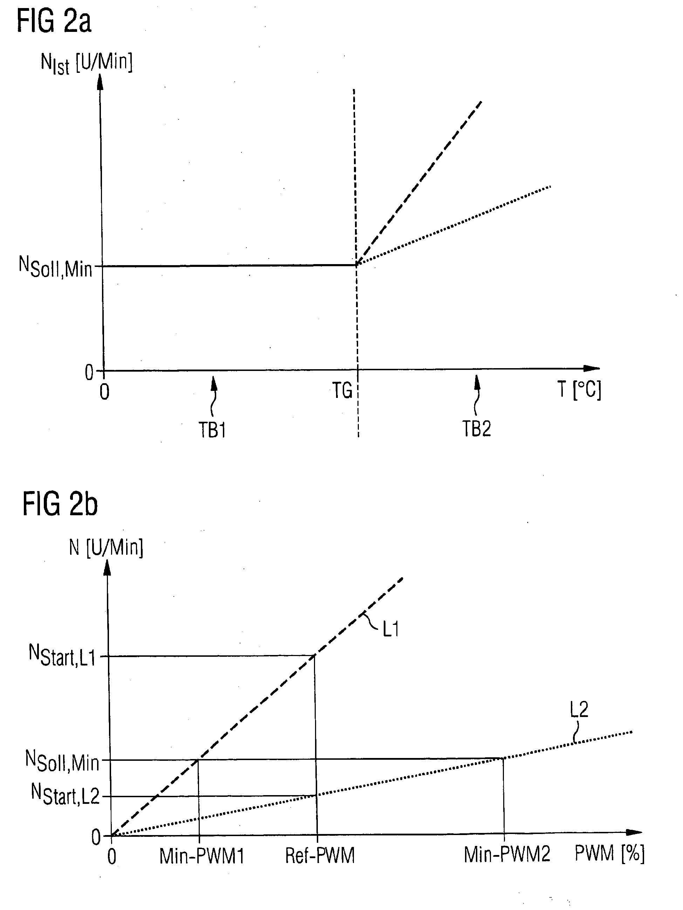

Figur 2a zeigt die Drehzahlen zweier verschiedener oder baugleicher Lüfter in Abhängigkeit einer Temperatur. Auf einer horizontalen Achse ist eine Temperatur T in °C aufgetragen. Auf einer vertikalen Achse ist eine Ist-Drehzahl N_{Ist} der Lüfter in Umdrehungen pro Minute U/Min aufgetragen.

In einem ersten Temperaturbereich TB1 sind die Lüfterdrehzahlen gleich und unabhängig von der Temperatur T. Beide Lüfter haben in diesem Temperaturbereich eine konstante Minimal-Soll-Drehzahl N_{Soll,Min}.

In einem zweiten Temperaturbereich TB2 sind die Lüfterdrehzahlen abhängig von der Temperatur T und voneinander verschieden. Die Lüfterdrehzahlen des einen Lüfters ist in diesem Temperaturbereich TB2 mit einer punktierten Linie gekennzeichnet und die des anderen Lüfters mit einer gestrichelten Linie. Mit steigender Temperatur steigen auch die Lüfterdrehzahlen der Lüfter unterschiedlich an.

Die auf der horizontalen Achse aufgetragene Temperatur entspricht der gemessenen Betriebstemperatur zweier zu kühlender elektronischer Komponenten in zwei Computersystemen. Die elektronischen Komponenten können zum Beispiel ein Prozessor des jeweiligen Computersystems sein.

Ist die Betriebstemperatur beider elektronischen Komponenten in dem ersten Temperaturbereich TB1, laufen beide Lüfter mit der gleichen Minimal-Soll-Drehzahl N_{soll,Min}. Dadurch entsteht bei gleicher oder ähnlicher Belastung ein Ton der nicht moduliert ist und dessen Frequenz der Lüfterdrehzahl entspricht.

Auch bei einer unterschiedlichen Belastung der Computersysteme oder unterschiedlicher Umgebungstemperatur bleiben die Drehzahlen der jeweiligen Lüfter auf der konstanten Minimal-Soll-Drehzahl N_{Soll,Min}, bis die Temperatur einer oder beider elektronischer Komponenten einen Schwellwert TG erreicht.

Erst wenn eines der Computersysteme deutlich mehr belastet wird und die Temperatur einer der elektronischen Komponenten infolgedessen sehr groß wird nämlich größer als TG, verändert sich die Soll-Drehzahl Nₛₒₗₗ des zugehörigen Lüfters entsprechend der Lüfterkennlinie in dem Temperaturbereich TB2. Der Schwellwert TG wurde in diesem Beispiel für beide elektronischen Komponenten gleich gewählt. Der Schwellwert kann auch für jeden Lüfter unterschiedlich gewählt werden.

Je nach Bauart des Lüfters ist für eine bestimmte Betriebstemperatur der elektronischen Komponente eine andere Lüfter-Steuerspannung im zweiten Temperaturbereich notwendig, um sehr gute Kühleigenschaften zu gewährleisten.

Figur 2b zeigt die Drehzahlen zweier Lüfter in Abhängigkeit von Tastverhältnissen pulsweitenmodulierter Ansteuerungssignale.

Auf einer horizontalen Achse ist das Tastverhältnis der pulsweitenmodulierten Ansteuerungssignale in Prozent % aufgetragen. Auf einer vertikalen Achse ist eine Drehzahl der Lüfter in Umdrehungen pro Minute U/Min aufgetragen.

Beim Start eines Lüfters L1 wird ein zugehöriger Transistor mit einem pulsweitenmodulierten Ansteuerungssignal angesteuert, dessen Tastverhältnis gleich einem Referenzwert Ref-PWM ist. Ein zu einem zweiten Lüfter L2 zugehöriger Transistor wird beim Start mit einem Ansteuerungssignal mit dem gleichen Referenzwert Ref-PWM eines Tastverhältnisses angesteuert.

Für den Lüfter L1 ergibt sich eine Lüfterdrehzahl von N_{Start,L1} und für den Lüfter L2 eine Lüfterdrehzahl von N_{Start,L2}. In diesem Ausführungsbeispiel ist die Lüfterdrehzahl des einen Lüfters N_{Start,L1} größer als die Minimal-Soll-Drehzahl N_{Soll,Min} und die Lüfterdrehzahl des zweiten Lüfters N_{Start,L2} ist kleiner als die Minimal-Soll-Drehzahl N_{Soll,Min}.

Damit beide Lüfter L1 und L2 mit der Minimal-Soll-Drehzahl N_{Soll,Min} laufen, ist für jeden der beiden Lüfter L1 bzw. L2 ein individuelles Tastverhältnis vonnöten. Für den Lüfter L1 ist das Tastverhältnis Min-PWM1. Das Tastverhältnis für den Lüfter L2 ist Min-PWM2. Der Transistor des Lüfters L2 muss mit einer höheren mittleren Leistung angesteuert werden als der Transistor des Lüfters L1, um die gleiche Minimal-Soll-Drehzahl zu erreichen.

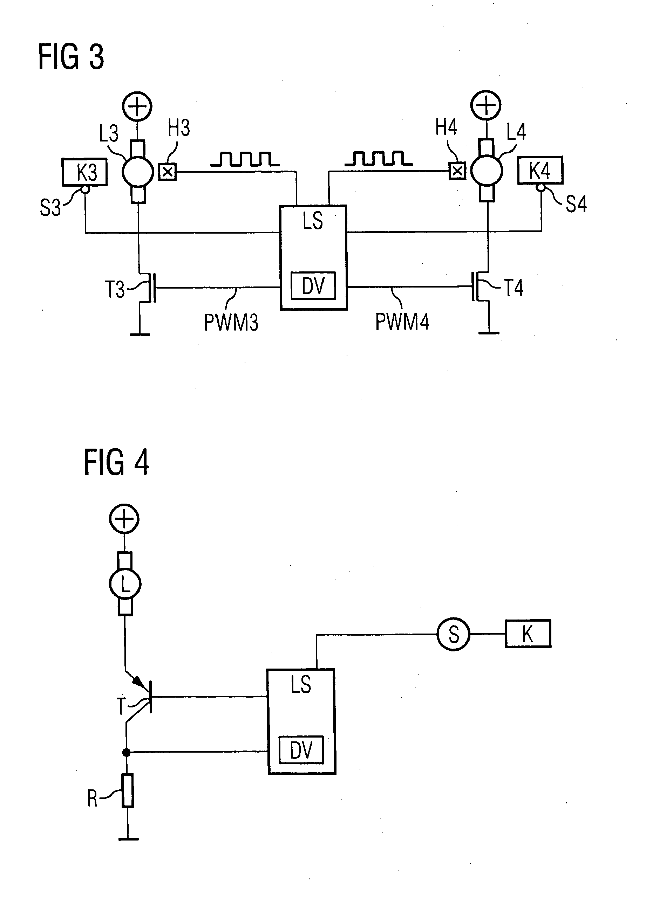

Figur 3 zeigt ein Blockschaltbild eines zweiten Ausführungsbeispiels der erfindungsgemäßen Lüftersteuerung in einem Computersystem.

Ein von einem Motor angetriebener Lüfter L3 kühlt eine elektronische Komponente K3 eines Computersystems. Ein zweiter von einem Motor angetriebener Lüfter L4 kühlt eine zweite elektronische Komponente K4 des Computersystems. Weitere Lüfter und elektronische Komponenten des Computersystems werden aus Gründen einer einfachen Erläuterung der Erfindung nicht explizit erwähnt, sind aber in der weiteren Beschreibung auch gemeint. Die zwei Lüfter L3 und L4 können verschiedene oder baugleiche Lüfter sein.

Die Temperatur der elektronischen Komponenten K3 und K4 wird von Temperatursensoren S3 bzw. S4 gemessen und an eine Lüftersteuerung LS weitergeleitet. Die Lüftersteuerung LS weist einen digitalen Vergleicher DV auf und steuert Transistoren T3 und T4 für die Lüfter L3 und L4 mit pulsweitenmodulierten Ansteuerungssignalen PWM3 und PWM4 an.

Die Ist-Drehzahl der Lüfter L3 und L4 wird jeweils von einem Drehzahlmesser H3 und H4 erfasst und ebenfalls an die Lüftersteuerung LS weitergeleitet.

Liegt die vom Temperatursensor S3 gemessene Temperatur in einem ersten Temperaturbereich der Lüfterkennlinie des Lüfters L3, soll eine Drehzahl des Lüfters L3 gleich einer vorgegebenen Minimal-Soll-Drehzahl sein. Wird für den Lüfter L3 vom digitalen Vergleicher DV eine Abweichung der Ist-Drehzahl von der Minimal-Soll-Drehzahl festgestellt, wird die Drehzahl des Lüfters L3 mit einem pulsweitenmodulierten Ansteuerungssignal PWM3 auf die Minimal-Soll-Drehzahl geregelt. Diese Regelung erfolgt, indem das Tastverhältnis des pulsweitenmodulierten Ansteuerungssignals PWM3 verändert wird.

Die Drehzahl des Lüfters L4 wird auch auf die vorgegebene Minimal-Soll-Drehzahl geregelt, wenn die vom Temperatursensor S4 gemessene Temperatur der elektronischen Komponente K4 in einem ersten Temperaturbereich der Lüfterkennlinie des Lüfters L4 liegt.

Beide Lüfter L3 und L4 laufen mit der gleichen Drehzahl nämlich der Minimal-Soll-Drehzahl, wenn die gemessenen Temperaturen der elektronischen Komponenten K3 und K4 einen Schwellwert nicht überschreiten.

Liegt die vom Temperatursensor S4 gemessene Temperatur in einem zweiten Temperaturbereich der Lüfterkennlinie des Lüfters L4, wird die Drehzahl des Lüfters L4 auf die Soll-Drehzahl geregelt, indem die Lüfter-Steuerspannung geregelt wird. Die Soll-Drehzahl ergibt sich aus der Lüfterkennlinie des Lüfters L4.

Ist auch die Temperatur der elektronischen Komponente K3 größer als ein Schwellwert und liegt in einem zweiten Temperaturbereich de Lüfterkennlinie des Lüfters L3, wird auch die Drehzahl des Lüfters L3 auf die nach der Lüfterkennlinie bekannte Soll-Drehzahl geregelt.

Eine genaue Steuerung der Drehzahlen der Lüfter L3 und L4 auf die vorgegebene Minimal-Soll-Drehzahl ist durch die erfindungsgemäße Lüftersteuerung LS möglich. Ein weiterer Vorteil ist die zentrale Ansteuerung aller sich im Computersystem befindlicher Lüfter auf die für alle gleichen vorgegebenen Minimal-Soll-Drehzahl im ersten Temperaturbereich der Lüfterkennlinien. Die erfindungsgemäße Lüftersteuerung ermöglicht einen subjektiv leisen Betrieb des Computersystems.

Figur 4 zeigt ein drittes Ausführungsbeispiel einer erfindungsgemäßen Lüftersteuerung.

Zwischen einer Betriebsspannung und das Bezugspotential 0 sind ein Lüfter L, ein Ausgangstransistor T und ein Messwiderstand R in Reihe geschaltet. Die Basis des Ausgangstransistors T ist mit einem Steuerausgang einer Lüftersteuerung LS verbunden, die den Transistor T mit einem analogen Ansteuerungssignal ansteuert. Die Lüftersteuerung weist einen digitalen Vergleicher DV auf. Eine Temperatur einer Komponente K wird von einem Temperatursensor S gemessen und an die Lüftersteuerung LS weitergeleitet.

Der Lüfter L verursacht durch die Kommutierung seiner Motorwicklungen auf seinen Stromversorgungszuleitungen Stromschwankungen, die proportional zur Ist-Drehzahl des Lüfters L sind. Diese vom Lüfter L verursachten Stromschwankungen, auch Kommutierungssignal genannt, können in diesem Fall der analogen Ansteuerung des Transistors T als eine Strommesswiderstandsspannung über den Messwiderstand R abgegriffen und anschließend beispielsweise durch einen Hochpass ausgekoppelt werden. Das erhaltene Signal wird dann über einen Komparator in Rechteckimpulse umgeformt, die an einen Messeingang der Lüftersteuerung LS gelegt werden.

Der digitale Vergleicher DV vergleicht die erfasste Ist-Drehzahl mit der vorgegebenen Minimal-Soll-Drehzahl für eine vom Temperatursensor S erfasste Temperatur im ersten Temperaturbereich der Lüfterkennlinie des Lüfters L. Bei einer Abweichung steuert die Lüftersteuerung LS den Transistor T zum Erreichen der Minimal-Soll-Drehzahl an.

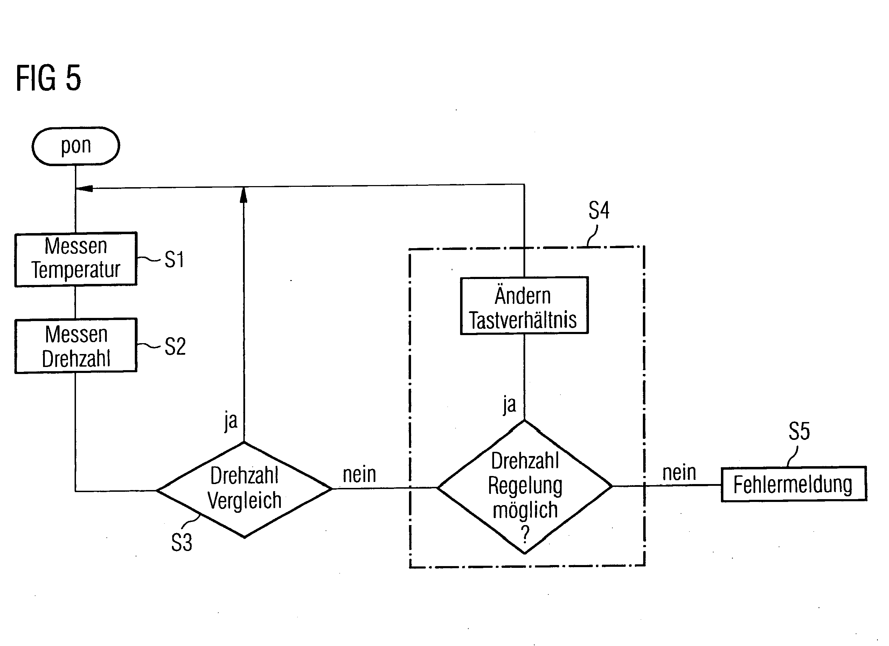

Figur 5 zeigt ein Flussdiagramm eines Verfahrens zur Einstellung der Drehzahl eines Lüfters.

In einem Schritt S1 wird die Temperatur einer elektronischen Komponente eines Computersystems gemessen. In einem Schritt S2 wird die Ist-Drehzahl des Lüfters erfasst. In einem Schritt S3 vergleicht der digitale Vergleicher, ob die Ist-Drehzahl der Minimal-Soll-Drehzahl gleich ist, wenn die erfasste Temperatur im ersten Temperaturbereich TB1 liegt. Bei einem negativen Ergebnis, das heißt "Ist-Drehzahl nicht gleich Minimal-Soll-Drehzahl", wird die Drehzahl des Lüfters in einem Schritt S4 zum Erreichen der Minimal-Soll-Drehzahl geregelt.

Bei einer erfassten Temperatur, die im zweiten Temperaturbereich TB2 der Lüfterkennlinie liegt, vergleicht der digitale Vergleicher im Schritt S4, ob die Ist-Drehzahl des Lüfters gleich der Soll-Drehzahl für die erfasste Temperatur ist. Bei einem negativem Ergebnis, das heißt "Ist-Drehzahl nicht gleich Soll-Drehzahl", wird die Drehzahl des Lüfters im Schritt S4 geregelt.

Ist ein Verändern der Drehzahl nicht möglich wird in einem Schritt S5 eine Fehlermeldung ausgegeben.

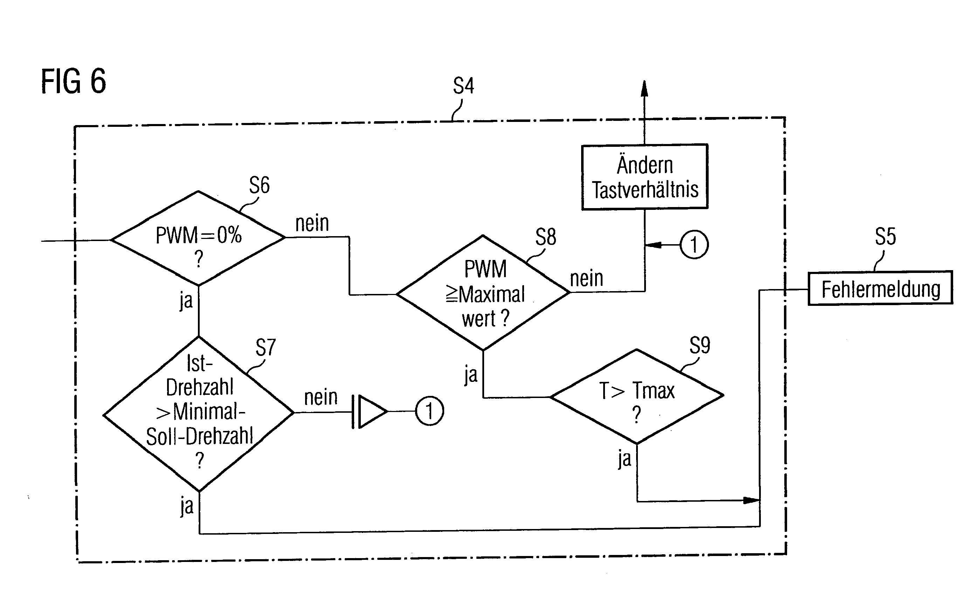

Figur 6 zeigt einen Ausschnitt aus einem detaillierten Flussdiagramm des Verfahrens zur Einstellung der Drehzahl eines Lüfters.

Die Lüftersteuerung regelt im Schritt S4 das Tastverhältnis des pulsweitenmodulierten Ansteuerungssignals, so dass eine Minimal-Soll-Drehzahl oder eine Soll-Drehzahl erreicht wird. Es wird in einem Schritt S6 geprüft, ob das Tastverhältnis PWM des pulsweitenmodulierten Ansteuerungssignals den Wert 0% erreicht, und in einem Schritt S7, ob die Ist-Drehzahl des Lüfters größer als die Minimal-Soll-Drehzahl ist. Bei positiver Feststellung erfolgt die Ausgabe der Fehlermeldung im Schritt S5.

Die Lüftersteuerung überprüft in einem Schritt S8, ob das Tastverhältnis PWM des pulsweitenmodulierten Ansteuerungssignals größer als der festzulegende Maximalwert (zum Beispiel 100%) ist und in einem Schritt S9, ob die erfasste Temperatur größer als eine maximal zulässige Betriebstemperatur Tmax ist. Bei positiver Feststellung, erfolgt die Ausgabe einer Fehlermeldung im Schritt S5.

Sind alle obigen Prüfungsbedingungen nicht erfüllt, ist eine Regelung der Drehzahl des Lüfters möglich und es folgt die Änderung des Tastverhältnisses.

Weitere Ausführungsbeispiele der Erfindung werden hier nicht weiter erläutert sind aber von der Erfindung umfasst.

### Bezugszeichen

- L1, L2: Lüfter
- K1, K2: elektronische Komponente
- C1, C2: Computersystem
- S1, S2: Temperatursensor
- LS1, LS2: Lüftersteuerung
- DV1, DV2: Digitaler Vergleicher
- PWM1, PWM2: pulsweitenmoduliertes Ansteuerungssignal
- H1, H2: Drehzahlmesser
- T1, T2: Transistor

- L3, L4: Lüfter
- K3, K4: elektronische Komponente
- S3, S4: Temperatursensor
- LS: Lüftersteuerung
- DV: Digitaler Vergleicher
- PWM3,PWM4: pulsweitenmoduliertes Ansteuerungssignal
- H3, H4: Drehzahlmesser
- T3, T4: Transistor

- L: Lüfter
- K: elektronische Komponente
- S: Temperatursensor
- R: Messwiderstand
- T: Transistor

- TB1: erster Temperaturbereich
- TB2: zweiter Temperaturbereich

- S1- S9: Verfahrensschritte

## Patentansprüche

1. Lüftersteuerung (LS) die dazu eingerichtet ist, einen Lüfter (L) in einem ersten Temperaturbereich einer Lüfterkennlinie auf einer konstanten Drehzahl zu halten,
**dadurch gekennzeichnet, dass**
die Lüftersteuerung (LS) einen digitalen Vergleicher (DV) aufweist zum Vergleich einer erfassten Ist-Drehzahl mit einer vorgegebenen Minimal-Soll-Drehzahl in dem ersten Temperaturbereich.

2. Lüftersteuerung (LS) nach Anspruch 1,
**dadurch gekennzeichnet, dass**
zur Ansteuerung des Lüfters (L) oder eines Transistors (T) eine Pulsweitenmodulation vorgesehen ist.

3. Lüftersteuerung (LS) nach Anspruch 1,
**dadurch gekennzeichnet, dass**
zur Ansteuerung des Lüfters (L) oder des Transistors (T) ein analoges Ansteuerungssignal vorgesehen ist.

4. Lüftersteuerung (LS) nach Anspruch 1,
**dadurch gekennzeichnet, dass**
die Lüftersteuerung (LS) dazu eingerichtet ist, eine Kalibrierung des Lüfters (L) vorzunehmen.

5. Lüftersteuerung (LS) nach Anspruch 2,
**dadurch gekennzeichnet, dass**
die Lüftersteuerung (LS) dazu eingerichtet ist, eine Fehlermeldung auszugeben, wenn ein pulsweitenmoduliertes Ansteuerungssignal ein Tastverhältnis von 0% aufweist und die Ist-Drehzahl des Lüfters (L) über der Minimal-Soll-Drehzahl liegt.

6. Lüftersteuerung (LS) nach Anspruch 2,
**dadurch gekennzeichnet, dass**
die Lüftersteuerung (LS) dazu eingerichtet ist, eine Fehlermeldung auszugeben, wenn ein pulsweitenmoduliertes Ansteuerungssignal ein Tastverhältnis von einem festzulegenden Maximalwert erreicht und eine erfasste Temperatur oberhalb einer zulässigen Betriebstemperatur liegt.

7. Verfahren zur Einstellung einer Drehzahl eines Lüfters mit den Schritten:
■ Messen einer Temperatur im Inneren eines Gerätesystems,
■ Messen einer Ist-Drehzahl des Lüfters,
■ Unwandeln des gemessenen Wertes der Ist-Drehzahl in einen digitalen Wert
■ Prüfen, ob der digitale Wert der Ist-Drehzahl des Lüfters gleich einer vorgegebenen Minimal-Soll-Drehzahl ist, wenn eine gemessene Temperatur in einem ersten Temperaturbereich einer Lüfterkennlinie des Lüfters liegt,
■ Regeln der Drehzahl des Lüfters bis zum Erreichen der Minimal-Soll-Drehzahl.

8. Verfahren nach Anspruch 6,
**dadurch gekennzeichnet, dass**
beim Regeln der Drehzahl des Lüfters, gemäß Anspruch 6, zum Erreichen der Minimal-Soll-Drehzahl das Tastverhältnis des pulsweitenmodulierten Ansteuerungssignals verändert wird.

9. Verfahren nach Anspruch 6,
**dadurch gekennzeichnet, dass**
beim Regeln der Drehzahl des Lüfters, gemäß Anspruch 6, zum Erreichen der Minimal-Soll-Drehzahl das analoge Ansteuerungssignal verändert wird.

10. Verfahren nach Anspruch 6,
**dadurch gekennzeichnet, dass**
bei einer Temperatur im zweiten Temperaturbereich geprüft wird, ob die Ist-Drehzahl gleich einer Soll-Drehzahl ist.

11. Verfahren nach Anspruch 6, zusätzlich die Schritte aufweisend:
■ Prüfen, ob das Tastverhältnis des pulsweitenmodulierten Ansteuerungssignals einen Wert von 0% erreicht und die Ist-Drehzahl größer als die Minimal-Soll-Drehzahl ist; bei positiver Feststellung Ausgeben einer Fehlermeldung,
■ Prüfen, ob das Tastverhältnis des pulsweitenmodulierten Ansteuerungssignals größer als oder gleich einem festzulegenden Maximalwert - zum Beispiel 100% - ist und die gemessene Temperatur oberhalb einer zulässigen Betriebstemperatur liegt; bei positiver Feststellung Ausgeben einer Fehlermeldung.
